# EUROPÄISCHE PATENTSCHRIFT

(11) **EP 2 502 249 B1**
(45) Veröffentlichungstag und Bekanntmachung des Hinweises auf die Patenterteilung: **14.01.2015**
(21) Anmeldenummer: 10781865.0
(22) Anmeldetag: 11.11.2010
(51) Int. Cl.: H01H 50/06

(54) **MOTORRELAIS**
MOTOR RELAY
RELAIS DE MOTEUR

(30) Priorität: 20.11.2009 DE 202009016051 U
(43) Veröffentlichungstag der Anmeldung: 26.09.2012
(73) Patentinhaber: Siemens Aktiengesellschaft, 80333 München (DE)
(72) Erfinder: BOHLMANN, Peer, 14621 Schönwalde (DE); LUDE, Gerald, 10627 Berlin (DE); PETTKER, Erich, 10247 Berlin (DE); RASCHKE, Bernd, 12621 Berlin (DE)
(86) Internationale Anmeldenummer: PCT/EP2010/067325
(87) Internationale Veröffentlichungsnummer: WO 2011/061117

(56) Entgegenhaltungen:
- DE-C1- 19 727 990
- US-B1- 6 563 408

## Beschreibung

Die Erfindung betrifft ein Motorrelais, insbesondere für Gleisstromkreise, mit einem Gehäuse, welches eine Grundplatte und eine Kappe mit einem Fenster, insbesondere aus durchsichtigem Kunststoff, für eine Anzeigeeinrichtung und einer drehbaren Klappe zur Abdeckung einer Prüfleiste aufweist.

Motorrelais werden insbesondere zum signaltechnisch sicheren Schalten eines Frei- oder Besetztzustandes bei Gleisstromkreisen eingesetzt. Bisher sind elektromechanische Motorrelais gebräuchlich, wobei das Gehäuse im Wesentlichen einen speziellen Motor, ein Hebelsystem und ein Kontaktsystem aufnimmt. Die Grundplatte des Gehäuses ist dabei als Aluminium-Gussteil ausgebildet, während die Kappe aus Kunststoff-Spritzguss besteht. Das beispielsweise aus Plexiglas bestehende Fenster ist vorzugsweise an einer Vorderseite der Kappe vorgesehen und dient der optischen Information bezüglich Belegt-, Frei- oder Übergangszustand mittels Zeigerbewegung über Farbfelder. Hinter der drehbaren Klappe befindet sich die für Prüfzwecke zugängliche Prüfleiste.

Elektromechanische Motorrelais sind üblicherweise mit einem Zweiphasen-Asynchronmotor mit Kurzschlussanker als Antrieb ausgestattet. Der Motor erhält sein Drehmoment durch zwei stromdurchflossene Wicklungen, wobei eine Gleisphasenwicklung über eine Gleis- und eine Hilfsphasenwicklung über ein Stellwerk gespeist werden. Beide Quellen stammen aus einem Dreiphasennetz. Das Drehmoment des Motors ist dem Produkt aus diesen beiden Strömen und dem Sinus des Winkels zwischen diesen Strömen proportional. Die Funktion des elektromechanischen Motorrelais im Gleisstromkreis ist bei einem Phasenwinkel zwischen Gleis- und Hilfsphasenspannung zwischen 60° und 120° gewährleistet. Optimal ist ein Phasenwinkel von 90°. Veränderungen des Phasenwinkels bzw. unterschiedliche Frequenzen der Hilfsphase und der Gleisphase haben eine Verringerung des Motordrehmomentes und damit eine Abfalltendenz des Motorrelais zur Folge. Daher ist es notwendig, mindestens einmal im Jahr eine vollständige Prüfung durchzuführen. Diese Prüfung ist zeit- und personalintensiv, da jedes einzelne elektromechanische Motorrelais aus seinem Betriebsumfeld ausgebaut und in einer separaten Prüfeinrichtung auf elektrische und mechanische Eigenschaften getestet und ggf. überarbeitet werden muss. Eine Neujustierung oder Überarbeitung des elektromechanischen Motorrelais ist nur in einer autorisierten Werkstatt und nicht am Einbauort des elektromechanischen Motorrelais möglich. Nachteilig bei elektromechanischen Motorrelais ist neben dem erheblichen Prüf- und Wartungsaufwand auch der komplizierte Grundaufbau, verbunden mit hohen Kosten für Herstellung und Betrieb.

Das Dokument DE 19 727 990 zeigt ein Motorrelais gemäß dem Oberbegriff des Anspruchs 1. Der Erfindung liegt daher die Aufgabe zugrunde, die elektromechanischen Komponenten durch eine elektronische Schaltung zu ersetzen, wobei vorhandene Gehäusebauteile weiter verwendbar sein sollen.

Erfindungsgemäß wird die Aufgabe dadurch gelöst, dass ein Träger zur Aufnahme mindestens einer Leiterkarte mit einer Schaltung zur elektronischen Realisierung des Motorrelais vorgesehen ist, wobei der Träger Befestigungselemente und Ausformungen aufweist, welche mit dem zur elektromechanischen Realisierung des Motorrelais konzipierten Gehäuse zusammenwirken.

Die Leiterkarten, die die elektronische Schaltung enthalten, werden an dem Träger fixiert, welcher zusammen mit den Lei-terkarten auf vorhandene Befestigungsstellen der Grundplatte montiert wird. Durch den Einsatz moderner Halbleitertechnik ist es möglich, das elektromechanische Motorrelais unter Beibehaltung der elektrischen Schnittstellen und des Gehäuses mit Grundplatte und Kappe zu ersetzen. Halbleiterkomponenten sind überwiegend wartungsfrei. Die Einsatzzeit des elektronischen Motorrelais ist nicht mehr von zeit- und personalintensiver Prüfung und Wartung, sondern nur noch vom Lebenszyklus der auf dem elektronischen Motorrelais verbauten elektronischen Bauelemente abhängig. Eine signaltechnisch sichere Umsetzung der elektronischen Lösung ist mittels Redundanz und interner Überwachung möglich. Durch den funktionskompatiblen Ersatz des elektromechanischen Motorrelais kann auch ein direkter Austausch in Bestandsanlagen erfolgen, wobei keinerlei Änderungen der vorhandenen Einsatzbedingungen erforderlich sind. Die Kompatibilität bezieht sich auch auf die mechanische Befestigung des Trägers mit den Leiterkarten auf der Grundplatte des Gehäuses, welches an sich für die elektromechanische Realisierung des Motorrelais konzipiert ist. Der Träger mit den Leiterkarten wird direkt an den vorhandenen Schraubvorrichtungen der Grundplatte befestigt. Auch die Kappe des vorhandenen Gehäuses kann unverändert weiterverwendet werden. Dazu ist der Träger mit entsprechenden Ausformungen, beispielsweise für die Anbringung der Prüfleiste, versehen.

Gemäß Anspruch 2 ist vorgesehen, dass der Träger die Leiterkarte U-förmig umfasst und mindestens eine einen Leiterkartenrand überragende Standfläche, erste Befestigungselemente zur Befestigung auf der Grundplatte, zweite Befestigungselemente zur Befestigung der Leiterkarte und dritte Befestigungsmittel zur Befestigung der Prüfleiste sowie eine Ausnehmung für die Anzeigeeinrichtung aufweist. Auf diese Weise ergibt sich eine stabile Halterung einer oder mehrerer Leiterkarten, wobei die Prüfleiste in unveränderter Position aufgenommen wird und die Anzeigeeinrichtung zur Funktionsanzeige ebenfalls in unveränderter Position beibehalten werden kann. Die Anzeigeeinrichtung, die bei dem herkömmlichen elektromechanischen Motorrelais als Zeigeranordnung hinter dem Fenster der Gehäuse-Kappe ausgebildet ist, kann dabei beispielsweise durch farbige LEDs ersetzt werden. Vorteilhaft ist weiterhin die fertigungsoptimierte Gestaltung des Leiterkarten-Trägers durch Einrahmung der Leiterkarten und über den Leiterkartenrand überstehende Standflächen. Letztlich sind Montage und Handhabung gegenüber dem bekannten elektromechanischen Motorrelais wesentlich vereinfacht.

Gemäß Anspruch 3 ist vorgesehen, dass die Schaltung der Leiterkarte eine Phasendifferenzerfassung zwischen einer bandpassgefilterten Hilfsphase und einer bandpassgefilterten Gleisphase und eine Pegelerfassung der bandpassgefilterten Gleisphase aufweist, wobei Phasendifferenz und Pegel ein Relais ansteuern, dessen Ausgang mit einem Stellwerk verbunden ist und wobei eine Überwachungseinrichtung vorgesehen ist, die mit den beiden Bandpassfiltern, den beiden Erfassungseinrichtungen, dem Relais und einer von der Hilfsphase abgezweigten Spannungsversorgung verbunden ist und einen Abschalter beaufschlagt, welcher im Fehlerfall das Relais in Gleisbesetztstellung schaltet. Durch Anschluss- und Funktionskompatibilität zu dem herkömmlichen elektromechanischen Motorrelais sind an dem Gleisstromkreis keinerlei Neueinstellungen erforderlich. Lediglich die üblichen Prüfhandlungen nach Komponentenaustausch sind auszuführen. Sämtliche Gleisfreimeldekriterien des herkömmlichen elektromechanischen Motorrelais, nämlich Pegel, Phasenwinkel und Frequenzen, werden auch durch das elektronische Motorrelais ausgewertet.

Die Erfindung wird nachfolgend anhand figürlicher Darstellungen näher erläutert. Es zeigen:
- Figur 1: eine schematische Darstellung der Einbindung eines elektronischen Motorrelais in einen Gleisstromkreis,
- Figur 2: die wesentlichen Komponenten des elektronischen Motorrelais,
- Figur 3: ein elektromechanisches Motorrelais nach dem Stand der Technik,
- Figur 4: einen Träger für das elektronische Motorrelais,
- Figur 5: den Träger nach Figur 4 mit Leiterkarten und Prüfleiste,
- Figuren 6 und 7: Details der Darstellung nach Figur 5,
- Figur 8: die Befestigung des elektronischen Motorrelais auf einer Grundplatte und
- Figur 9: das elektronische Motorrelais mit Grundplatte und Kappe.

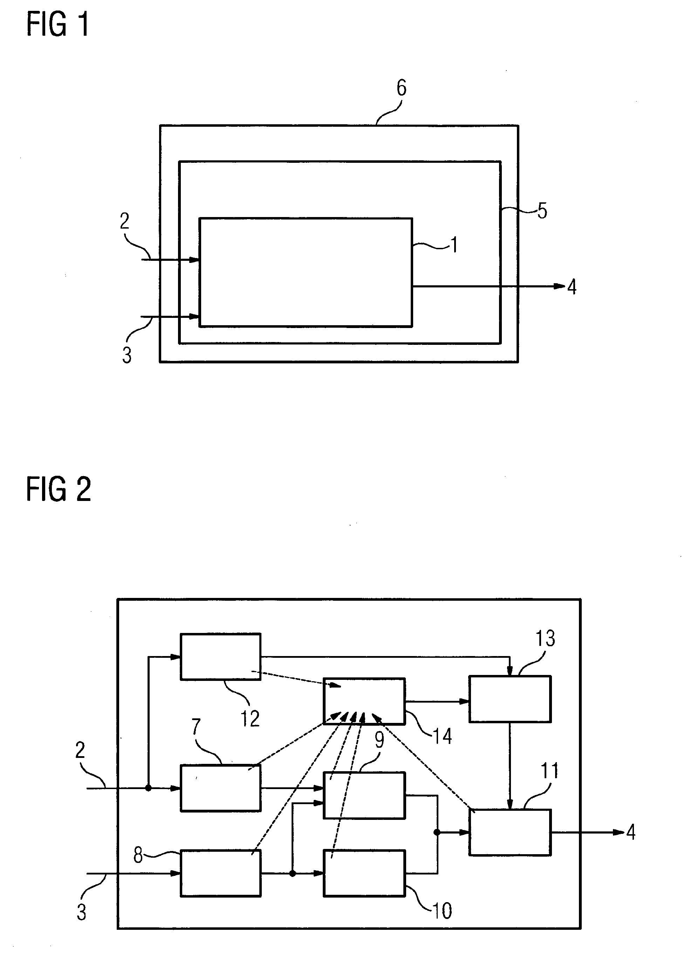

Figur 1 zeigt den grundsätzlichen Aufbau einer Frei-Belegt-Auswertung für einen nicht dargestellten Gleisstromkreis. Ein elektronisches Motorrelais 1 ist mit üblichen Eingängen Hilfsphase 2 und Gleisphase 3 sowie mit einem Ausgang zu einem Stellwerk 4 verbunden. Das elektronische Motorrelais 1 ist dabei auf einer Steckergrundplatte 5 montiert, welche in ein Gestell 6 eingepasst ist.

Die wesentlichen elektronischen Baugruppen des elektronischen Motorrelais 1 sind in Figur 2 veranschaulicht. Die Hilfsphase 2 und die Gleisphase 3 werden über Bandpassfilter 7 und 8 einer Phasendifferenzerfassung 9 zugeführt. Die bandpassgefilterte Gleisphase 3 ist außerdem mit einer Pegelerfassung 10 verbunden. Phasendifferenz und Pegel steuern ein Relais 11, dessen Signalausgang mit dem Stellwerk 4 verbunden ist. Eine Spannungsversorgung 12 ist von der Hilfsphase 2 abgezweigt und über einen Abschalter 13 mit dem Relais 11 verbunden. Der Abschalter 13 wird von einer Überwachung 14 beaufschlagt, welche die ordnungsgemäße Funktion der Spannungsversorgung 12, der beiden Bandpassfilter 7 und 8, der Phasendifferenzerfassung 9, der Pegelerfassung 10 und des Relais 11 überwacht und im Fehlerfall den Abschalter 13 ansteuert, welcher ggf. das Relais 11 in den sicheren Zustand, d. h. in den Gleisbesetztzustand, umschaltet.

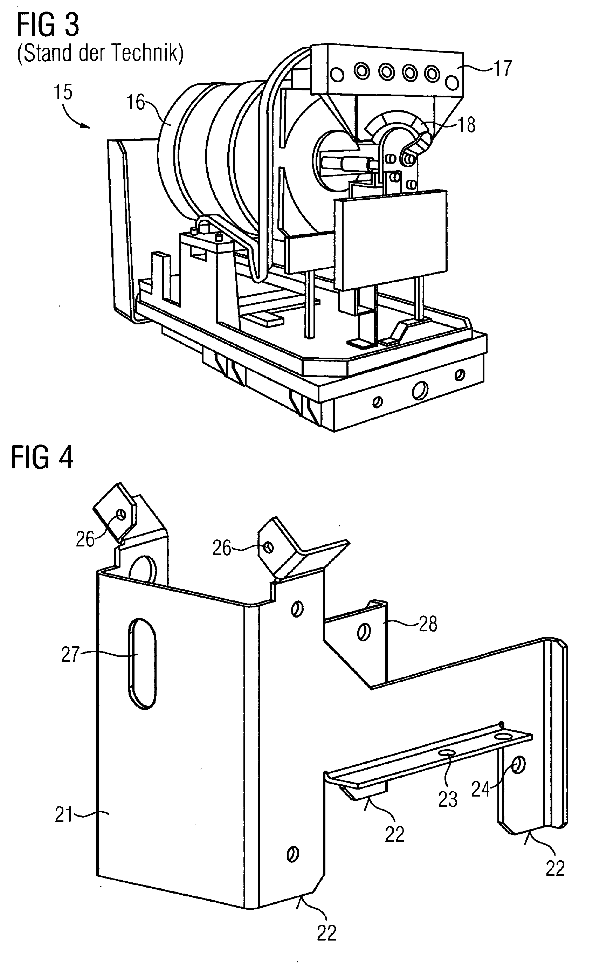

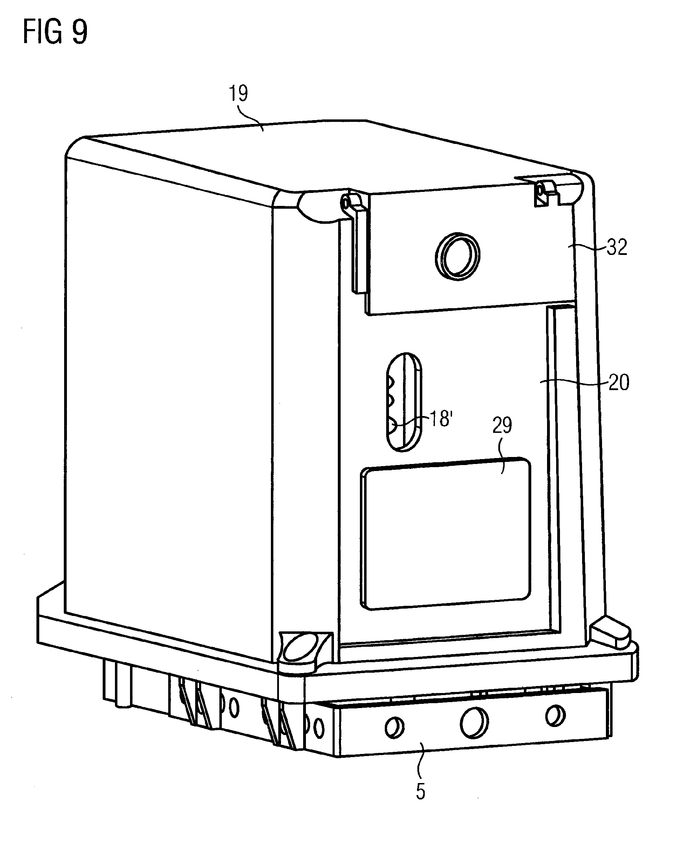

In Figur 3 ist ein elektromechanisches Motorrelais 15 nach dem Stand der Technik dargestellt. Dieses besteht im Wesentlichen aus einem Zweiphasen-Asynchronmotor 16, einer Prüfleiste 17 und einer Anzeigeeinrichtung 18, welche auf der Steckergrundplatte 5 montiert und bei laufendem Betrieb mit einer in Figur 9 dargestellten Kappe 19 mit Fenster 20 abgedeckt sind.

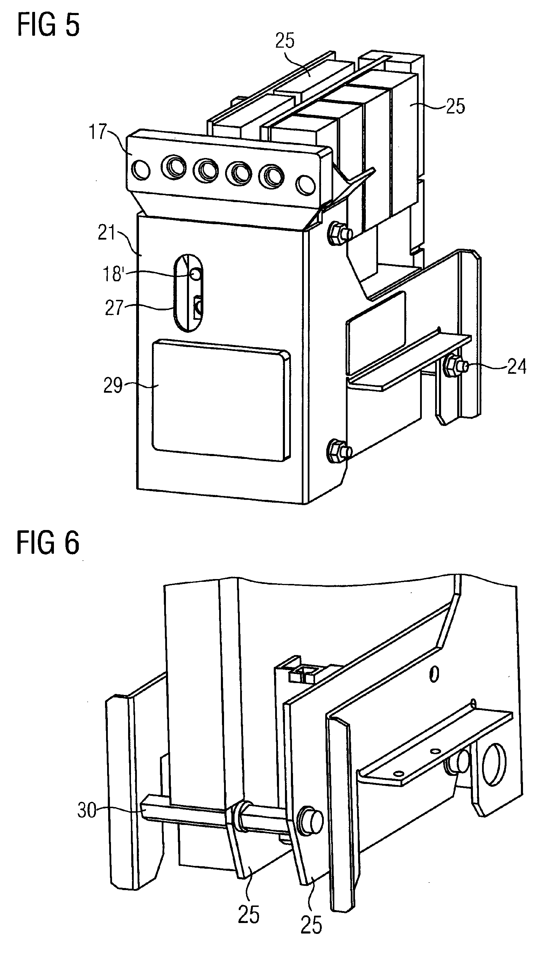

Um dieses elektromechanische Motorrelais 15 durch das elektronische Motorrelais 1 unter Beibehaltung der elektrischen Peripherie sowie der Steckergrundplatte 5 und der Kappe 19 zu ersetzen, ist ein Träger 21 vorgesehen, der in Figur 4 dargestellt ist. Dieser Träger 21 besitzt mindestens eine Standfläche 22, Befestigungsstellen 23 zur Befestigung auf der Steckergrundplatte 5, Befestigungsstellen 24 zur Befestigung von Leiterkarten 25 (Figur 5), welche die elektronische Schaltung für das elektronische Motorrelais 1 aufnehmen, Befestigungsstellen 26 für die Prüfleiste 17, eine Ausnehmung 27 für eine Anzeigeeinrichtung 18' (Figur 5) modernerer Bauart, beispielsweise auf LED-Basis, sowie mindestens eine Biegekante 28 als Kantenschutz für Kabel.

Dieser Träger 21 ermöglicht den Einbau der Leiterkarten 25 anstelle des elektromechanischen Motorrelais 15 mit Prüfleiste 17 und Anzeigeeinrichtung 18' an im Wesentlichen unveränderter Position, wie in Figur 5 dargestellt. An der Vorderseite des Trägers 21 ist außerdem Platz für ein Typenschild 29.

Figur 6 zeigt einen unteren Bereich einer rückwärtigen Ansicht der Trägerkonstruktion nach Figur 5. Es ist ersichtlich, dass zwei Leiterkarten 25 an Befestigungsstellen 24 mittels Schraubbolzen 30 befestigt sind.

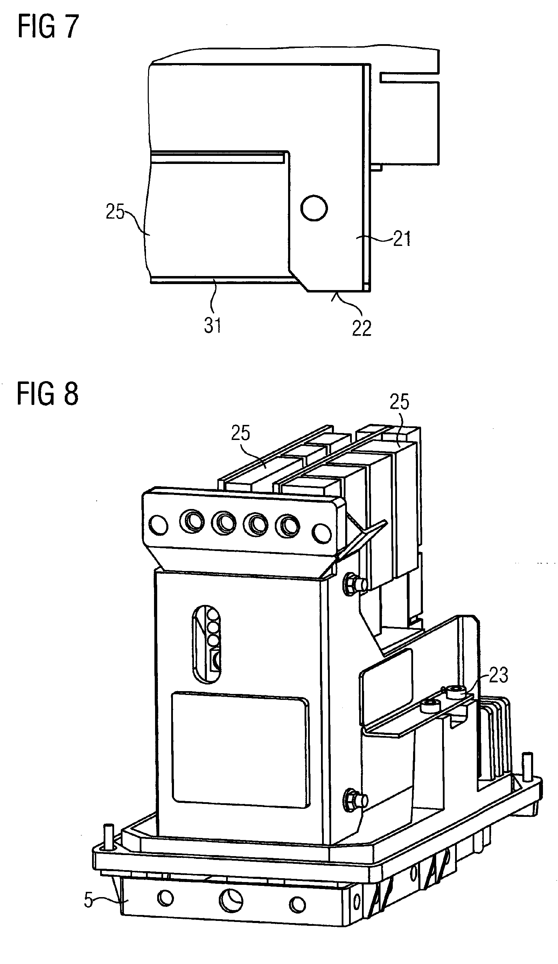

Figur 7 zeigt ein Detail einer Seitenansicht der Trägerkonstruktion nach Figur 5. Ersichtlich ist die Standfläche 22 des Trägers 21, welche eine Leiterkartenkante 31 derart überragt, dass der Träger 21 auf der Steckergrundplatte 5 aufsteht, nicht aber die Leiterkarte 25.

Die Montage des Trägers 21 mit dem elektronischen Motorrelais 1 in Form zweier Leiterkarten 25 ist in Figur 8 dargestellt, während Figur 9 das komplette Gehäuse mit auf der Steckergrundplatte 5 befestigter Kappe 19 zeigt. Die Kappe 19 ist mit einer drehbaren Klappe 32 versehen, wodurch die Prüfleiste 17 geschützt, aber bedarfsweise zugänglich ist. Das Fenster 20 der Kappe 19 besteht aus durchsichtigem Kunststoff. Dadurch sind die Anzeigeeinrichtung 18' und das Typenschild 29 gegen Verschmutzung und Beschädigung geschützt.

## Patentansprüche

1. Motorrelais, insbesondere für Gleisstromkreise, mit einem Gehäuse, welches eine Steckergrundplatte (5) und eine Kappe (19) mit einem Fenster (20), insbesondere aus durchsichtigem Kunststoff, für eine Anzeigeeinrichtung (18, 18') und einer drehbaren Klappe (32) zur Abdeckung einer Prüfleiste (17) aufweist,
**dadurch gekennzeichnet, dass**
ein Träger (21) zur Aufnahme mindestens einer Leiterkarte (25) mit einer Schaltung zur elektronischen Realisierung des Motorrelais (1) vorgesehen ist, wobei der Träger (21) Befestigungselemente (23, 24, 26) und Ausformungen aufweist, welche mit dem zur elektromechanischen Realisierung des Motorrelais (15) konzipierten Gehäuse zusammenwirken.

2. Motorrelais nach Anspruch 1,
**dadurch gekennzeichnet, dass**
der Träger (21) die Leiterkarte (25) U-förmig umfasst und mindestens eine einen Leiterkartenrand (31) überragende Standfläche (22), erste Befestigungsstellen (23) zur Befestigung auf der Steckergrundplatte (5), zweite Befestigungsstellen (24) zur Befestigung der Leiterkarte (25) und dritte Befestigungsstellen (26) zur Befestigung der Prüfleiste (17) sowie eine Ausnehmung (27) für die Anzeigeeinrichtung (18') aufweist.

3. Motorrelais nach einem der vorangehenden Ansprüche,
**dadurch gekennzeichnet, dass**
die Schaltung der Leiterkarte (25) eine Phasendifferenzerfassung (9) zwischen einer bandpassgefilterten (7) Hilfsphase (2) und einer bandpassgefilterten (8) Gleisphase (3) und eine Pegelerfassung (10) der bandpassgefilterten (8) Gleisphase (3) aufweist, wobei Phasendifferenz und Pegel ein Relais (11) ansteuern, dessen Ausgang mit einem Stellwerk (4) verbunden ist und wobei eine Überwachungseinrichtung (14) vorgesehen ist, die mit den beiden Bandpassfiltern (7, 8), den beiden Erfassungseinrichtungen (9, 10), dem Relais (11) und einer von der Hilfsphase (2) abgezweigten Spannungsversorgung (12) verbunden ist und einen Abschalter (13) beaufschlagt, welcher im Fehlerfall des Relais (11) in Gleisbesetztstellung schaltet.

## Claims

1. Motor relay, in particular for track circuits, having a housing comprising a base plug plate (5) and a cap (19) having a window (20), in particular made of transparent plastic, for a display device (18, 18') and a rotatable flap (32) for covering a test strip (17),
**c h a r a c t e r i s e d in that**
a carrier (21) for receiving at least one circuit board (25) having a circuit for electronically implementing the motor relay (1) is provided, wherein the carrier (21) has fastening elements (23, 24, 26) and mouldings which interact with the housing conceived for electromechanically implementing the motor relay (15).

2. Motor relay according to claim 1,
**characterised in that**
the carrier (21) comprises the circuit board (25) in a U-shape and at least one base (22) projecting over a circuit board edge (31), first fastening points (23) for fastening to the base plug plate (5), second fastening points (24) for fastening the circuit board (25) and third fastening points (26) for fastening the test strip (17) as well as a recess (27) for the display device (18').

3. Motor relay according to one of the preceding claims,
**characterised in that**
the circuit of the circuit board (25) comprises phase difference detection (9) between a bandpass-filtered (7) auxiliary phase (2) and a bandpass-filtered (8) track phase (3) and level detection (10) of the bandpass-filtered (8) track phase (3), wherein phase difference and level control a relay (11), the output of which is connected to a signalling installation (4) and wherein a monitoring device (14) is provided which is connected to the two bandpass filters (7, 8), the two detection devices (9, 10), the relay (11) and a voltage supply (12) branched from the auxiliary phase (2) and applies a circuit breaker (13) which in the event of a fault in the relay (11) switches to track occupied position.

## Revendications

1. Relais de moteur, notamment pour un circuit de voie, comprenant une carcasse, qui a une plaque (5) de fondation formant connecteur et un capot (19) ayant un hublot (20), notamment en matière plastique transparente, pour un dispositif (18, 18') d'indication et un volet (32) tournant de recouvrement d'une réglette (17) de contrôle,
**caractérisé en ce**
**qu'**il est prévu un support (21) de réception d'au moins une carte (25) à circuit imprimé ayant un circuit pour la réalisation électronique du relais (1) de moteur, le support (21) ayant des éléments (23, 24, 26) de fixation et des conformations, qui coopèrent avec le carter conçu pour la réalisation électromécanique du relais (15) de moteur.

2. Relais de moteur suivant la revendication 1,
**caractérisé en ce que**
le support (21) entoure en forme de U la carte (25) à circuit imprimé et a au moins une surface (22) de base dépassant du bord (31) de la carte à circuit imprimé, des premiers points (23) de fixation pour la fixation sur la plaque (5) d'assise formant connecteur, des deuxièmes points (24) de fixation pour la fixation de la carte (25) à circuit imprimé et des troisièmes points (26) de fixation pour la fixation de la réglette (17) de contrôle ainsi qu'un évidement (27) pour le dispositif (18') d'indication.

3. Relais de moteur suivant l'une des revendications précédentes,
**caractérisé en ce que**
le circuit de la carte (25) à circuit imprimé a une détection (9) de différence de phase entre une phase (2) auxiliaire filtrée (7) en passe bande et une phase (3) de voie filtrée (8) en passe bande et une détection (10) de niveau de la phase (3) de voie filtrée (8) en passe bande, la différence de phase et le niveau commandant un relais (11), dont la sortie est reliée à un poste (4) de signalisation et dans lequel il est prévu un dispositif (14) de contrôle, qui est relié aux deux filtres (7, 8) passe bande, aux deux dispositifs (9, 10) de détection, au relais (11) et à une alimentation (12) en tension dérivée de la phase (2) auxiliaire et excite un interrupteur (13), qui, si le relais (11) est défectueux, se met en position d'occupation de voie.
